# EUROPÄISCHE PATENTANMELDUNG

(11) **EP 3 725 910 A1**
(43) Veröffentlichungstag der Anmeldung: **21.10.2020**
(21) Anmeldenummer: 20166615.3
(22) Anmeldetag: 30.03.2020
(51) Int. Cl.: C23C 14/00, C23C 14/08, C23C 14/54

(54) **VERFAHREN ZUR HERSTELLUNG EINER SILIKAT-SCHUTZSCHICHT**

(30) Priorität: 17.04.2019 DE 102019110203
(71) Anmelder: Deutsches Zentrum für Luft- und Raumfahrt e.V., 51147 Köln (DE)
(72) Erfinder: LEISNER, Vito, 51147 Köln (DE)
(74) Vertreter: dompatent von Kreisler Selting Werner - Partnerschaft von Patent- und Rechtsanwälten mbB

(57) **Zusammenfassung**

Die vorliegende Erfindung betrifft ein Verfahren zur Herstellung einer Silikat-Schutzschicht mittels reaktivem Magnetronsputtern, wobei eine stöchiometrische Abscheidung durch Kontrolle der Temperatur sichergestellt wird.

## Beschreibung

Die vorliegende Erfindung betrifft ein Verfahren zur Herstellung einer Silikat-Schutzschicht mittels reaktivem Magnetronsputtern, wobei eine stöchiometrische Abscheidung der Konstituenten Silizium, Metall und Sauerstoff durch Kontrolle der Prozesstemperatur sichergestellt wird.

Das reaktive Magnetronsputtern ist ein bekanntes und industriell verbreitetes Verfahren zur Applikation von keramischen oder metallisch/keramischen Schichten. Die Schichtabscheidung erfolgt innerhalb einer Sputterkammer im Vakuum von einem oder mehreren metallischen Targets, die in üblicher Weise von einem Edelgas - meist Argon - zerstäubt werden. Als sekundäres Gas wird ein reaktives Gas in die Vakuumkammer der Beschichtungsanlage eingeleitet, das mit den Targetatomen eine Verbindung eingeht, welche dann auf der Oberfläche abgeschieden wird. Dieses sekundäre Gas (auch ein tertiäres Gas ist möglich) entstammt meist folgender Auswahl: Sauerstoff, Stickstoff, Kohlenwasserstoffe.

Das aus prozesstechnischer Sicht größte Problem besteht beim reaktiven Sputtern darin, die Vergiftung der Targetoberfläche zu unterbinden. Hierbei bildet sich, bei der Verwendung von zwei Targets aus unterschiedlichen Materialien, beispielsweise Silizium und ein weiteres Metall, auf der zu erodierenden Fläche des reaktiveren Targets eine Verbindung des Metalls mit dem Reaktivgas. Dies führt zu einer erheblich verminderten Zerstäubungsausbeute was in den meisten Fällen unterbunden werden soll. Der Vergiftungsgrad hängt nichtlinear mit der Verfügbarkeit des Reaktivgases zusammen, die über den Gasfluss oder den Partialdruck des reaktiven Gases eingestellt werden kann.

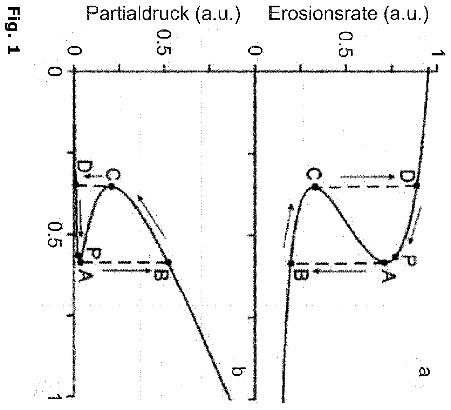

Messkurven, die die Erosionsrate des Targets in Abhängigkeit vom Gasfluss bzw. Partialdruck in Abhängigkeit vom Gasfluss zeigen, sind im Stand der Technik bekannt. Eine typische Kurve ist beispielsweise in E. Särhammar; K. Strijckmans; T. Nyberg; S. Van Steenberge; S. Berg; D. Depla: "A study of the process pressure influence in reactive sputtering aiming at hysteresis elimination". In: Surface and Coatings Technology 232 (2013), S. 357-361, offenbart. Fig. 1 zeigt eine entsprechende schematische Darstellung. Die Kurven zeigen eine Hysterese, deren genauer Verlauf von vielen Parametern, u.a.: Targetmaterial, Reaktivgas, Prozessgas, Partialdruck des Prozessgases, Targetgröße, Größe des Rezipienten, Target-Leistung, Target-Substrat Abstand, Target-Target Abstand und Pumpleistung, abhängig ist.

Üblicherweise wird versucht, den Sputtervorgang bzw. -prozess nahe am Übergangsbereich (Punkt P in Fig. 1) ablaufen zu lassen. An dieser Stelle verändert sich der Wert einer gemessenen Größe, zum Beispiel die Entladespannung an der Kathode (Target), bei nur geringfügiger Erhöhung der Verfügbarkeit des Reaktivgases. Wird dieser Punkt überschritten, kann er nicht durch einfache Verringerung des Reaktivgases rückgängig gemacht werden. Dieser Bereich ist jedoch sensibel gegenüber geringen Schwankungen im Prozess, so dass dort die Aufrechterhaltung eines dauerhaften, stabilen Prozesses schwierig ist. Ein bekanntes Mittel zur Erzielung der gewünschten Prozessparameter ist die Prozessregelung über den Partialdruck des Reaktivgases. Hierzu wird ein Massenspektrometer oder ein Plasma-Emissions Monitorsystem für die im Prozess verwendeten Gasspezies benötigt, das in den Regelkreislauf eingebunden ist und den Fluss des Reaktivgases hiernach regelt. Dies erfordert einen sehr schnellen PID Regelkreis, der zudem kompliziert anzupassen ist. Weitere Möglichkeiten sind u.a. die Messung von optischen Intensitäten von Emissionslinien der Gasspezies, Bestimmung der Spannungen am Target oder die Partialdruckmessung.

Die vorbekannten Regelungsverfahren können daher erst in den Prozess eingreifen, wenn der Partialdruck im Inneren der Sputterkammer steigt. Verwendet man neben Silizium sehr reaktive Metalle, wie etwa Yttrium, Ytterbium oder andere Seltenerdenmetalle, kann die Regelung der bekannten Methoden zu spät eingreifen. Durch die hohe Reaktivität der Targetmaterialen ist die Regelung üblicherweise so träge, dass sienicht mehr schnell genug erfolgen kann um den Prozess im gewünschten Übergangsbereich zu halten. Insbesondere bei der Verwendung mehrerer Targetmaterialien und mehrerer Kathoden kommt es unter Umständen zu Fluktuationen in der Stöchiometrie der Elementzusammensetzung der Schicht. Zudem werden teure und aufwändige Messaparaturen benötigt, wie beispielsweise Massenspektrometer, welche zusätzlich in die Sputteranlage eingebunden werden müssen. Die Regelung (PID) ist zudem kompliziert einzustellen, da die Reaktionszeit sehr kurz ist und physikalische Prozesse zeitlich verzögert auftreten.

Überraschenderweise hat sich gezeigt, dass die Messung und Kontrolle der Temperatur innerhalb der Sputterkammer geeignet ist, das Reaktivsputtern zu kontrollieren, eine Vergiftung des Targets zu verhindern und so ein quasi stöchiometrisches Abscheiden einer Schicht mit einer definierten Zusammensetzung zu ermöglichen.

In einer ersten Ausführungsform wird die der vorliegenden Erfindung zu Grunde liegende Aufgabe gelöst durch ein Verfahren zur Herstellung einer stöchiometrischen Schicht auf einer Oberfläche mittels Magnetronsputtern in einer Sputterkammer, wobei
die Schicht wenigstens zwei Elemente A und C aufweist, wobei das erste Element A mittels eines Targets in der Sputterkammer bereitgestellt wird, und das zweite Element C als Reaktivgas in die Sputterkammer eingeleitet wird, dadurch gekennzeichnet, dass
während des Sputtervorgangs die Temperatur im Inneren der Sputterkammer gemessen wird und
auf Grund einer Temperaturänderung während des Sputtervorgangs der Zufluss des Reaktivgases C in die Sputterkammer und damit der Partialdruck dieses Reaktivgases in der Sputterkammer geregelt wird.

Bei Messungen der Temperatur im Innern einer Sputterkammer wurde überraschenderweise festgestellt, dass es im Inneren der Sputterkammer während des Sputtervorgangs zu einem Anstieg der Temperatur kommt. Die Entladespannung und der Kathodenstrom steigen leicht linear an bzw. fallen leicht ab. An einem bestimmten Punkt fällt die Temperatur deutlich ab. Mit Verzögerung Ändern sich auch Entladespannung und Kathodenstrom. Die Änderung der Entladespannung und des Kathodenstorms zeigen eine bereits vorliegende Vergiftung des Targets an. Der Abfall der Temperatur erfolgt jedoch deutlich vor der Änderung von Strom und Spannung. Üblicherweise beträgt die Zeitdifferenz zwischen Temperaturänderung und Änderung bei Strom/Spannung wenigstens 30 Sekunden, vorzugsweise wenigstens 60 Sekunden, insbesondere 100 Sekunden oder mehr. Innerhalb dieser Zeitspanne kann der Partialdruck des Reaktivgases reguliert werden, wodurch Strom und Spannung stabil bleiben. So wird eine Vergiftung des Targets weitestgehend vermieden und eine stöchiometrische Abscheidung von Schichten mit einer Schichtdicke von mehreren µm ermöglicht.

Als Temperatur im Inneren einer Sputterkammer wird im Rahmen der vorliegenden Erfindung insbesondere die Temperatur eines in der Sputterkammer befindlichen Gasgemisches verstanden. Dieses Gasgemisch kann an der Messstelle teilweise oder vollständig ionisiert vorliegen. Die Temperaturmessung erfolgt daher insbesondere an einer einem Dampfpartikelstrom ausgesetzten Stelle, insbesondere direkt am Substrat oder in Substratnähe.

Das erfindungsgemäße Verfahren ermöglicht die Abscheidung einer Schicht über einen längeren Zeitraum. Diese Schicht weist eine stöchiometrische Zusammensetzung auf, was mit nach dem Stand der Technik üblichen Verfahren nicht oder nur schwer möglich ist. Eine Vergiftung des Targets von Element A kann im Wesentlichen vermieden werden. Eine Vergiftung des Targets würde dazu führen, dass die Abscheidung der gewünschten Schicht sich um den Faktor 5 oder mehr verlängert. Da die Vergiftung mit dem erfindungsgemäßen Verfahren im Wesentlichen vermieden werden kann, wird ein kostengünstiges Herstellungsverfahren vorliegend bereitgestellt.

Element im Sinne der vorliegenden Erfindung ist ein chemisches Element oder eine Molekül. Wird das Element als Target bereitgestellt, handelt es sich um ein chemisches Element, welches bei Normalbedingungen fest ist. Wird das Element als Reaktivgas bereitgestellt, so ist es ein Element oder Molekül, welches bei Normalbedingungen gasförmig ist.

Das erfindungsgemäße Verfahren ermöglicht nicht nur die Abscheidung einer Schicht, die die Elemente A und C aufweist. Durch das Einbringen eines weiteren Reaktivgases D (tertiäres Gas) wird die Abscheidung einer Schicht ermöglicht, welche die Elemente A, C und D aufweist. Die genaue stöchiometrische Zusammensetzung der Schicht ist von den eingesetzten Elementen sowie den Reaktionsbedingungen während des Sputterns abhängig. Regelbar ist die Stöchiometrie aufgrund des Partialdruckes des oder der Reaktivgase(s). Auch in dieser Ausführungsform, in welcher drei Elemente abgeschieden werden, führt eine gemessene Temperaturänderung dazu, dass der Partialdruck im Inneren der Kammer reguliert wird. Dabei kann nur der Partialdruck des ersten Reaktivgases C geregelt werden. Alternativ kann nur der Partialdruck des zweiten Reaktivgases D eingestellt werden. Vorzugsweise werden sowohl der Partialdruck des ersten Reaktivgases C als auch des zweiten Reaktivgases D geregelt.

Geregelt bedeutet in diesem Zusammenhang, dass auf Grund der gemessenen Temperaturänderung der Zufluss des ersten und/oder zweiten Reaktivgases verändert wird. Hierdurch kann der Partialdruck im Inneren der Kammer des jeweiligen Reaktivgases erniedrigt oder erhöht werden, je nachdem, was aufgrund der ablaufenden Reaktion gewünscht ist.

Es ist vorzugsweise auch möglich, dass die abgeschiedene Schicht weiterhin ein Element B aufweist, welches mittels eines weiteren Targets in der Sputterkammer bereitgestellt wird. Durch das Anlegen einer Entladespannung an jeder Kathode, die für jedes Target individuell eingestellt werden kann, welche den Sputtervorgang startet, wird dann nicht nur das Element A sondern auch das Element B in die Gasphase im Inneren des Reaktors überführt, wo die Elemente A und B mit dem Element C und ggf. Element D reagieren und eine Schicht auf der zu beschichtenden Substrat-/Proben-/Bauteiloberfläche bilden. Erfindungsgemäß ist es somit möglich eine Schicht aus 2 Elementen A und C, oder aus drei Elementen A und B und C oder A und C und D, oder aus 4 Elementen A und B und C und D bereit zu stellen.

Anstelle zweier Targets aus dem Elementen A und B könnten auch keramische Targets, welche die Elemente A und B in der gewünschten stöchiometrischen Zusammensetzung aufweisen, eingesetzt werden. Bei der Verwendung keramischer Targets steigen jedoch die Kosten für die Abscheidung, da hier eine höhere Wattzahl für das Verfahren notwendig ist. Die Kosten steigen etwa um den Faktor 10 je zusätzlich notwendigem Watt. Dagegen können Targets, die nur ein Element aufweisen, mit Gleichstrom kostengünstig betrieben werden.

Mit dem erfindungsgemäßen Verfahren ist es nun erstmals möglich auf einfache, kostengünstige Art und Weise Schichten mit definierter Stöchiometrie mit einer Schichtdicke im µm-Bereich herzustellen. Bisher konnten entsprechende Schichten nur mittels keramischen Spritzens aufgetragen werden. Sollten diese mittels Sputtertechnik aufgetragen werden, bestand das Problem, dass die bekannten Regelungstechniken erst in das Verfahren eingreifen, wenn der Partialdruck steigt. Je nach Reaktivität des Targetmaterials kann die Regelung dann ggfls. nicht schnell genug sein. Bei der Verwendung mehrerer Targetmaterialien und mehrerer Kathoden kommt es u.U. zu Fluktuationen in der Stöchiometrie der Elementzusammensetzung der Schicht. Es musste zudem ein teures Massenspektrometer oder anderes Messsystem beschafft und in die bereits bestehende Anlage aufwändig eingebunden werden.

Die bisherige Kenngröße zur Regelung aus dem Stand der Technik ist der Partialdruck des/der Reaktivgase(s) beziehungsweise die Bestimmung der Gaszusammensetzung oder der Spannung am Target. In der vorliegenden Erfindung wird die Prozesstemperatur als neue Kenn- und Regelungsgröße erstmals genutzt. Die Temperaturmessung kann dabei sowohl direkt am Substrat bzw. Bauteil erfolgen oder an einer dem Dampfpartikelstrom ausgesetzten anderen Stelle wie z.B. dem Bauteilhalter. Für das vorliegende Verfahren wird ein geeignetes Mittel zur Temperaturmessung in Substratnähe, zum Beispiel ein Thermoelement oder ein Pyrometer, benötigt. Entsprechende Geräte sind kostengünstig verfügbar und können einfach in bestehende Sputtergeräte integriert werden. Die Empfindlichkeit des Temperatursignals ist zudem erheblich höher als die der bisher verwendeten Mess- und Regelgrößen. Dadurch ist die erfindungsgemäße Regelung des Gasflusses beim reaktiven Sputtern für auf Dauerbetrieb ausgelegte, industrielle Beschichtungsprozesse erheblich schneller möglich. Das vorliegende erfindungsgemäße Verfahren zielt darauf ab, eine Stabilität im Dauerbetrieb zu gewährleisten und gegebenenfalls zu regeln bevor der Partialdruck des/der Reaktivgase(s) steigt, beziehungsweise es bereits zu partieller Vergiftung des/der Targets kommt.
Als Reaktivgas können Sauerstoff, Stickstoff oder Kohlenwasserstoffe eingesetzt werden. Entsprechende Reaktivgase sind im Stand der Technik bekannt. Entsprechende Gase können als erstes und/oder zweites Reaktivgas eingesetzt werden. Werden erstes und zweites Reaktivgas eingesetzt, sind diese voneinander verschieden. Geeignete Kohlenwasserstoffe sind alle bei Raumtemperatur gasförmigen Kohlenwasserstoffe, insbesondere sind es kurzkettige Kohlenwasserstoffe mit 1 bis 5 C-Atomen, besonders bevorzugt Methan oder Ethan, insbesondere Ethan, da mit steigender C-Kettenlänge die Reaktivität abnimmt.

Als Element, welches in Form eines Targets bereitgestellt wird, sind insbesondere metallische Elemente geeignet. Vorzugsweise handelt es sich u solche chemischen Elemente, insbesondere Metalle, welche unter den Bedingungen in der Sputterkammer mit den/dem eingesetzten Reaktivgas(en) reagieren. Besonders bevorzugt ist das erste Element A und das Element B jeweils unabhängig voneinander ausgewählt ist aus Yttrium, Ytterbium, sowie alle Seltenerdenelemente, Silizium, Hafnium, Zirkon, wobei Element A und Element B voneinander verschieden sind, wenn beide im Verfahren eingesetzt werden. Seltenerdelemente im Sinne der vorliegenden Erfindung sind chemische Elemente der 3. Nebengruppe des Periodensystems mit Ausnahme des Actiniums und die Lanthanoide. Beispiele für Seltenerdelemente sind Scandium, Lanthan, Cer, Praseodym, Neodym, Promethium, Samarium, Europium, Yttrium, Gadolinium, Terbium, Dysprosium, Holmium, Erbium, Thulium, Ytterbium und Lutetium.

Das erfindungsgemäße Verfahren ermöglicht somit die Herstellung von Schichten aus wenigstens 2 Elementen, wobei der Partialdruck des wenigstens einen Reaktivgases auf Grund von Temperaturänderungen regelmäßig angepasst wird. Das Funktionsprinzip einer solchen Regelung ist für jedes System (z.B. Anlage, verwendete Werkstoffe, verwendete Reaktivgase) individuell anzupassen sein. Die Regelung läuft dann wie folgt ab: fällt die Temperatur nach einem möglicherweise vorhergehenden Temperaturanstieg ab, wird der Reaktivgasfluss reduziert, bis sich die Temperatur wieder erhöht. Innerhalb dieses Regelintervalls wird der Gasfluss permanent angepasst, so dass die Temperatur um einen Mittelwert schwankt.

In einer bevorzugten Ausführungsform ist die Temperaturänderung somit eine Temperaturzunahme und in Folge dieser wird der Partialdruck von Element C und/oder Element D in der Sputterkammer reduziert. In einer weiteren bevorzugten Ausführungsform ist die Temperaturänderung eine Temperaturabnahme und in Folge dieser wird der Partialdruck von Element C und/oder Element D in der Sputterkammer erhöht.

Besonders bevorzugt umfasst das erfindungsgemäße Verfahren die folgenden Schritte:
i) Bereitstellen wenigstens eines ersten Elements A in Form eines Targets im Inneren einer Sputterkammer,
ii) Bereitstellen wenigstens eines gasförmigen Elements C;
iii) Bereitstellen einer Oberfläche im Inneren einer Sputterkammer; Anlegen eines Vakuums in der Kammer und Durchspülen der Kammer mit einem Inertgas;
iv) Anlegen einer Spannung am Target und Einbringen des Elements C in die Kammer, wodurch es zum Abscheiden einer Schicht AₓC_{y} auf der Oberfläche kommt, und Messen der Temperatur während des Abscheidevorgangs, wobei die Indizes x und y die Stöchiometrie angeben und diese von der Wahl von A und C abhängig ist;
v) Detektion eines Temperaturanstiegs im Inneren der Kammer, wodurch der Partialdruck des Elements C in der Kammer erhöht wird, anschließende
vi) Detektion eines Temperaturabfalls im Inneren der Kammer, wodurch der Partialdruck des Elements C in der Kammer gesenkt wird und
vii) Wiederholung der Schritte v) und vi) so lange, bis eine Schicht mit der gewünschten Dicke auf der Oberfläche abgeschieden ist;
viii) Abschalten der Spannung.

In den Schritten i) und ii) kann auch das zweite Element B beziehungsweise das zweite Reaktivgas D entsprechend zur Verfügung gestellt werden. Durch die Wiederholung der Schritte v) und vi) wird eine kontinuierliche Abscheidung ermöglicht. Die Temperatur schwankt um einen Mittelwert, der von den Elementen A, B, C und D, und der verwendeten Apparatur abhängig ist. Der Partialdruck der/des Reaktivgase(s) schwankt ebenfalls um einen Mittelwert. Dieser ergibt sich auf Grund der Regelung. Hierdurch wird eine Vergiftung des/der Targets der Elemente A und B - soweit eingesetzt - quasi vermieden.

Das Magnetronsputtern findet in einer Sputterkammer statt. Diese wird nach Evakuierung üblicherweise mit einem Inertgas gefüllt. Geeignete Inertgase sind Argon und/oder Stickstoff, insbesondere Argon. Während der Beschichtung wird die Kammer fortlaufend evakuiert und ihr die Gase kontinuierlich zugefügt, so dass sich ein stationärer Zustand bei einem gewünschten Prozessdruck einstellt.

Das erfindungsgemäße Verfahren ermöglicht die Herstellung von Schichten definierter Stöchiometrie mit einem kostengünstigen Verfahren. Die so erhaltenen Schichten können beispielsweise als EBC (environmental barrier coating) oder TBC (thermal barrier coating) verwendet werden.

Gemäß einem weiteren Aspekt betrifft die Erfindung ein Magnetronsputtervorrichtung zur Durchführung des erfindungsgemäßen Verfahrens, wobei die Vorrichtung grundsätzlich eine Sputterkammer, eine Temperatursensoreinrichtung, mindestens ein Target als Kathode, eine Anode, mindestens ein Substrat, das ebenfalls mit einer negativen Spannung beaufschlagt werden kann, sowie eine Regeleinrichtung umfasst. Es ist dabei vorgesehen, dass in die Sputterkammer während des Sputterprozesses ein definierter Volumenstrom mindestens eines Inertgases und eines Reaktivgases zuführbar sind und dass die Temperatursensoreinrichtung zur Messung der Temperatur des Sputterprozesses ausgestaltet ist. Die Regeleinrichtung ist dabei derart ausgestaltet, den Volumenstrom des mindestens einen zugeführten Reaktivgases in Abhängigkeit der über die Temperatursensoreinrichtung ermittelten Werte zu verändern. Es kann dabei ebenfalls vorgesehen sein über die Regeleinrichtung die Menge des zugeführten Volumens des mindestens einen Reaktivgases in Abhängigkeit einer detektierten Änderung des Temperaturwertes vorzunehmen.

Im Sinne der vorliegenden Erfindung können Merkmale aus einzelnen Ausführungsformen mit allen anderen Ausführungsformen auf beliebige Art und Weise miteinander kombiniert werden.

Im nachfolgenden Ausführungsbeispiel wird die vorliegende Erfindung in nichtlimitierender Weise erläutert.

### Ausführungsbeispiel:

Für das reaktive Metall Yttrium (Element A) mit Sauerstoff als Sekundärgas (Element C), das eine ausgeprägte Hysterese zeigt, wurde das Prozessverhalten untersucht. Die Funktionalität wurde ebenfalls für den dualen Betrieb mit zwei Targets (zweites Target: Silizium) erfolgreich überprüft.

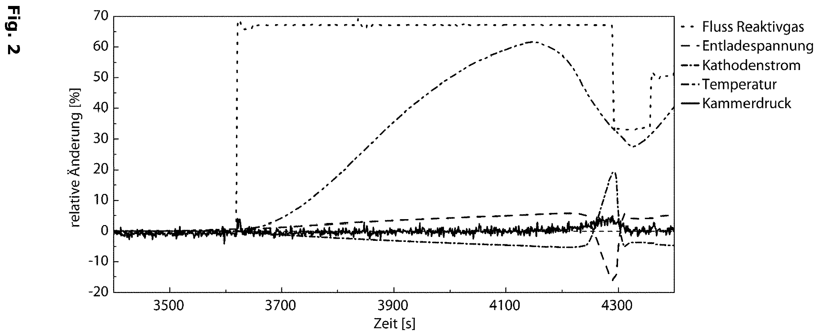

In Fig. 2 ist der Verlauf verschiedener Kenngrößen des Prozesses dargestellt, bei dem die Zerstäubungsausbeute über die Leistung an der Kathode eingestellt wird. Die Erhöhung des Sauerstoff-Flusses (blau) an einen Arbeitspunkt nah am ersten kritischen Punkt der Hysterese bewirkte in der Folge einen signifikanten Anstieg der Temperatur (orange) auf circa 60 % des Ausgangswertes. Der Gesamtdruck (schwarz) blieb unberührt. Die Entladespannung (rot) sowie der Kathodenstrom (grün) stiegen, bzw. fielen leicht linear. Nach einiger Zeit fiel die Temperatur deutlich ab, während die eigentlichen Leistungsparameter der Targets unverändert waren.

An dieser Stelle kann der Sauerstoff-Fluss zurückgenommen (geregelt) werden, sodass sich der Prozess stabilisiert, ohne dass die Zerstäubung hiervon beeinflusst würde. Dieses Regelfenster ist mit über 70 Sekunden gegenüber dem Stand der Technik deutlich größer. Der Abfall der Temperatur erfolgt dabei deutlich eher als es Änderungen im Kammerdruck oder der Targetspannung anzeigen. Dies verlängert die verfügbare Reaktionszeit erheblich und erlaubt damit eine einfachere Regeltechnik, da auf eine PID Regelung verzichtet und auf übliches Equipment (Temperaturmessung) zurückgegriffen werden kann.

## Patentansprüche

1. Verfahren zur Herstellung einer stöchiometrischen Schicht auf einer Oberfläche mittels Magnetronsputtern in einer Sputterkammer, wobei die Schicht wenigstens zwei Elemente A und C aufweist, wobei das erste Element A mittels eines Targets in der Sputterkammer bereitgestellt wird, und das zweite Element C als erstes Reaktivgas in die Sputterkammer eingeleitet wird,
**dadurch gekennzeichnet, dass**
während des Sputtervorgangs die Temperatur im Inneren der Sputterkammer gemessen wird und
auf Grund einer Temperaturänderung während des Sputtervorgangs der Zufluss des Reaktivgases C in die Sputterkammer und damit der Partialdruck dieses Reaktivgases in der Sputterkammer geregelt wird.

2. Verfahren nach Anspruch 1, **dadurch gekennzeichnet, dass** die Temperaturmessung direkt am Substrat oder an einer einem Dampfpartikelstrom ausgesetzten anderen Stelle erfolgt, insbesondere in Substratnähe.

3. Verfahren nach Anspruch 1 oder 2, **dadurch gekennzeichnet, dass** die weiterhin ein Element D aufweist, wobei Element D als zweites Reaktivgas in die Sputterkammer eingeleitet wird und
auf Grund der Temperaturänderung der Partialdruck des ersten Reaktivgases C und/oder der des zweiten Reaktivgases D geregelt wird.

4. Verfahren nach einem der Ansprüche 1 bis 3, **dadurch gekennzeichnet, dass** die Schicht weiterhin ein Element B aufweist, welches mittels eines Targets in der Sputterkammer bereitgestellt wird.

5. Verfahren nach einem der Ansprüche 1 bis 4, **dadurch gekennzeichnet, dass** das erste Reaktivgas B und das zweite Reaktivgas C jeweils unabhängig voneinander ausgewählt sind aus der Gruppe, die aus Sauerstoff, Stickstoff, und Kohlenwasserstoffen mit 1 bis 5 C-Atomen besteht, wobei das erste Reaktivgas B und das zweite Reaktivgas C voneinander verschieden sind.

6. Verfahren nach einem der Ansprüche 1 bis 5, **dadurch gekennzeichnet, dass** das erste Element A und das Element B jeweils unabhängig voneinander ausgewählt ist aus Yttrium, Ytterbium ,Silizium, Hafnium, Zirkonium und Seltenerdelmenten, wobei Element A und Element B voneinander verschieden sind.

7. Verfahren nach einem der Ansprüche 1 bis 6, **dadurch gekennzeichnet, dass** die Temperaturänderung eine Temperaturzunahme ist und in Folge dieser der Partialdruck von Element C und/oder Element D in der Sputterkammer reduziert wird.

8. Verfahren nach einem der Ansprüche 1 bis 7, **dadurch gekennzeichnet, dass** die Temperaturänderung eine Temperaturabnahme ist und in Folge dieser der Partialdruck von Element C und/oder Element D in der Sputterkammer erhöht wird.

9. Verfahren nach einem der Ansprüche 1 bis 8, **dadurch gekennzeichnet, dass** es die folgenden Schritte umfasst:
i) Bereitstellen wenigstens eines ersten Elements A in Form eines Targets im Inneren einer Sputterkammer,
ii) Bereitstellen wenigstens eines gasförmigen Elements C;
iii) Bereitstellen einer Oberfläche im Inneren einer Sputerkammer; Anlegen eines Vakuums in der Kammer und Durchspülen der Kammer mit einem Inertgas;
iv) Anlegen einer Spannung und Einbringen des Elements C in die Kammer, wodurch es zum Abscheiden einer Schicht AₓC_{y} auf der Oberfläche kommt, und Messen der Temperatur während des Abscheidevorgangs;
v) Detektion eines Temperaturanstiegs im Inneren der Kammer, wodurch der Partialdruck des Elements C in der Kammer abgesenkt wird, anschließende
vi) Detektion eines Temperaturabfalls im Inneren der Kammer, wodurch der Partialdruck des Elements C in der Kammer erhöht wird und
vii) Wiederholung der Schritte v) und vi) so lange, bis eine Schicht mit der gewünschten Dicke auf der Oberfläche abgeschieden ist;
viii) Abschalten der Spannung.

10. Verfahren nach Anspruch 9, **dadurch gekennzeichnet, dass** das Inertgas Argon oder Stickstoff ist.

11. Schicht erhalten nach einem Verfahren gemäß einem der Ansprüche 1 bis 10.

12. Verwendung einer Schicht nach Anspruch 11 als EBC (environmental barrier coating) oder TBC (thermal barrier coating).

13. Magnetronsputtervorrichtung zur Durchführung eines Verfahrens gemäß einem der Ansprüche 1 bis 10 umfassend:
- eine Sputterkammer
- eine Temperatursensoreinrichtung
- mindestens ein Target als Kathode,
- mindestens ein Substrat als Anode, sowie
- eine Regeleinrichtung,
wobei in die Sputterkammer während des Sputterprozesses ein definierter Volumenstrom mindestens eines Reaktivgases zuführbar ist,
wobei die Temperatursensoreinrichtung zur Messung der Temperatur des Sputterprozesses ausgestaltet ist,
wobei die Regeleinrichtung derart ausgestaltet ist, den Volumenstrom des mindestens einen zugeführten Reaktivgases in Abhängigkeit der über die Temperatursensoreinrichtung ermittelten Werte zu verändern.

14. Magnetronsputtervorrichtung nach Anspruch 13, **dadurch gekennzeichnet, dass** die Temperatursensoreinrichtung an einer einem Dampfpartikelstrom ausgesetzten Stelle in Substratnähe angebracht ist.
